# EUROPÄISCHE PATENTANMELDUNG

(11) **EP 1 113 493 A1**
(43) Veröffentlichungstag der Anmeldung: **04.07.2001**
(21) Anmeldenummer: 00128568.3
(22) Anmeldetag: 27.12.2000
(51) Int. Cl.: H01L 21/8246, H01L 27/115, H01L 21/02

(54) **Verfahren zur Herstellung eines ferroelektrischen Halbleiterspeichers**

(30) Priorität: 03.01.2000 DE 10000005
(71) Anmelder: Infineon Technologies AG, 81669 München (DE)
(72) Erfinder: Dehm, Christine, 90403 Nürnberg (DE); Hartner, Walter, 81829 München (DE); Kastner, Marcus, 85521 Ottobrunn (DE); Schindler, Günther, 80802 München (DE)
(74) Vertreter: Graf Lambsdorff, Matthias, Dr.

(57) **Zusammenfassung**

Auf einem Halbleitersubstrat (1) wird ein Schalttransistor (2) geformt und auf diesen eine Isolationsschicht (4) aufgebracht, auf welcher dann ein Speicherkondensator mit Elektroden (7, 9) aus Platin und mit ferroelektrischem oder paraelektrischem Dielektrikum (8) gebildet wird. Um das Dielektrikum (8) bei den weiteren Prozeßschritten vor dem Eindringen von Wasserstoff zu schützen, wird in die Isolationsschicht (4) eine erste Barriereschicht (5) eingebettet und nach Fertigstellung des Speicherkondensators eine zweite Barriereschicht (10) abgeschieden, die sich mit der ersten Barriereschicht (5) verbindet.

## Beschreibung

Die Erfindung betrifft ein Verfahren zur Herstellung eines Halbleiterbauelements gemäß Patentanspruch 1. Insbesondere betrifft die vorliegende Erfindung ein Verfahren zur Herstellung einer nicht-flüchtigen Speicherzelle mit einem Schalttransistor und einem Speicherkondensator, dessen Kondensatorplatten ein Platinmetall enthalten und zwischen denen ein ferroelektrisches oder paraelektrisches Material als Dielektrikum eingesetzt ist.

Konventionelle mikroelektronische Halbleiterspeicher-Bauelemente (DRAMs) bestehen im wesentlichen aus einem Auswahl-oder Schalttransistor und einem Speicherkondensator, in welchem zwischen zwei Kondensatorplatten ein dielektrisches Material eingefügt ist. Als Dielektrikum werden üblicherweise zumeist Oxid- oder Nitridschichten verwendet, die eine Dielektrizitätskonstante von maximal etwa 8 aufweisen. Zur Verkleinerung des Speicherkondensators sowie zur Herstellung von nicht-flüchtigen Speichern werden "neuartige" Kondensatormaterialien (Ferroelektrika oder Paraelektrika) mit deutlich höheren Dielektrizitätskonstanten benötigt. Ein paar dieser Materialien sind in der Publikation "Neue Dielektrika für Gbit-Speicherchips" von W. Hönlein, Phys. B1. 55 (1999), genannt. Zur Herstellung von ferroelektrischen Kondensatoren für Anwendungen in nicht-flüchtigen Halbleiterspeicher-Bauelementen hoher Integrationsdichte können z.B. ferroelektrische Materialien, wie SrBi₂(Ta,Nb)₂O₉ (SBT oder SBTN), Pb(Zr, Ti)O₃ (PZT), oder Bi₄Ti₃O₁₂ (BTO) als Dielektrikum zwischen den Kondensatorplatten eingesetzt werden. Es kann aber auch ein paraelektrisches Material, wie beispielsweise (Ba,Sr)TiO₃ (BST), zum Einsatz kommen.

Die Verwendung dieser neuartigen Dielektrika, Ferroelektrika oder Paraelektrika stellt jedoch die Halbleiterprozeßtechnologie vor neue Herausforderungen. Zunächst lassen sich diese neuartigen Materialien nämlich nicht mehr mit dem traditionellen Elektrodenmaterial polykristallines Silizium kombinieren. Deshalb müssen inerte Elektrodenmaterialien, wie beispielsweise Platinmetalle oder deren leitfähige Oxide (z.B. RuO₂), eingesetzt werden. Der Grund hierfür liegt darin, daß nach dem Abscheiden des Ferroelektrikums dieses in einer Sauerstoff-haltigen Atmosphäre bei Temperaturen von etwa 550-800°C gegebenenfalls mehrfach getempert ("konditioniert") werden muß. Zur Vermeidung von unerwünschten chemischen Reaktionen des Ferroelektrikums mit den Elektroden werden diese daher zumeist aus Platin oder einem anderen ausreichend temperaturstabilen und inerten Material, wie einem anderen Platinmetall (Pd, Ir, Rh, Ru, Os), gefertigt.

Zur Integration der Speicherkondensatoren sind Prozeßschritte notwendig, die in Wasserstoff-haltiger Umgebung stattfinden. So ist beispielsweise zur Konditionierung der Metallisierung und der Transistoren eine Temperung in Formiergas notwendig, welches zu 95 % aus Stickstoff (N₂) und zu 5 % aus Wasserstoff (H₂) zusammengesetzt ist. Das Eindringen von Wasserstoff in den prozessierten Speicherkondensator, d.h. in das Dielektrikum, kann jedoch durch Reduktionsreaktionen zu einer Degradation der oxidischen Keramiken des Dielektrikums führen. Des weiteren können die plasma-unterstützte Abscheidung von Intermetalloxiden (PECVD) bzw. der Siliziumnitrid-Passivierungsschicht aufgrund des hohen Wasserstoffgehalts in den Schichten eine Reduktion des ferro- bzw. paraelektrischen Materials des Dielektrikums bewirken.

Im Stand der Technik wurde bisher versucht, das Problem durch Abscheiden einer Passivierungsschicht auf den Speicherkondensator zu lösen. In der U.S.-PS 5,523,595 wird beispielsweise ein Herstellungsverfahren für ein Halbleiterbauelement beschrieben, bei welchem ein Schalttransistor in einem Halbleitersubstrat gebildet wird, eine erste Isolationsschicht auf dem Schalttransistor abgeschieden wird, auf der ersten Isolationsschicht ein mit dem Schalttransistor gekoppelter ferroelektrischer Speicherkondensator geformt wird, oberhalb des Speicherkondensators eine zweite Isolationsschicht aufgebracht wird und auf diese eine Barriereschicht gegen das Eindringen von Wasserstoff aus TiON abgeschieden wird. Durch diese bisher bekannte Barriereschicht wird das Eindringen von Wasserstoff durch die obere Elektrode des Speicherkondensators verhindert. Allerdings ist eine Diffusion von Wasserstoff durch die erste Isolationsschicht, und der unteren Elektrode in das Dielektrikum weiterhin möglich und kann somit zu einer Degradation des Speicherkondensators führen. Auf den Wasserstoffanteil im Formiergas kann andererseits nicht verzichtet werden, da durch den Wasserstoff freie Bindungen ("dangling bonds") im Halbleiter, insbesondere an den Grenzflächen zu Elektroden, und im Gate-Oxid abgesättigt werden sollen. Eine Diffusion des Wasserstoffs durch die untere Elektrode des Speicherkondensators und eine nachfolgende Schädigung des Ferroelektrikums ist dabei nicht auszuschließen.

Es ist demnach Aufgabe der vorliegenden Erfindung, ein Verfahren zur Herstellung eines Halbleiterspeichers anzugeben, bei welchem ein Speicherkondensator, der ein ferroelektrisches oder paraelektrisches Material für das Dielektrikum verwendet, ausreichend gegen das Eindringen von Wasserstoff geschützt werden kann.

Die vorliegende Erfindung löst diese Aufgabe durch ein Verfahren zur Herstellung eines Halbleiterbauelements, bei welchem
a) auf einem Halbleitersubstrat ein Schalttransistor geformt wird,
b) auf dem Schalttransistor eine Isolationsschicht aufgebracht wird, wobei in die Isolationsschicht eine erste Barriereschicht, insbesondere gegen das Eindringen von Wasserstoff eingebettet wird,
c) auf die Isolationsschicht ein mit dem Schalttransistor gekoppelter Speicherkondensator enthaltend eine untere und eine obere Elektrode und eine dazwischen abgeschiedene metalloxidhaltige Schicht aufgebracht wird,
d) in einem vertikalen Ätzschritt die Isolationsschicht außerhalb des Speicherkondensators bis zu einer derartigen Tiefe entfernt wird, wobei die erste Barriereschicht nach außen freigelegt wird,
e) auf den Speicherkondensator und auf die Isolationsschicht und auf die erste Barriereschicht eine zweite Barriereschicht, insbesondere gegen das Eindringen von Wasserstoff, aufgebracht wird.

Die metalloxidhaltige Schicht ist dabei vorzugsweise ein ferroelektrisches oder paraelektrisches Material.

Vorzugsweise wird der Schalttransistor mit dem Speicherkondensator in der Weise verbunden, daß nach dem Aufbringen der Isolationsschicht in diese ein Kontaktloch bis zu einem Anschlußbereich des Schalttransistors, beispielsweise einem Drain-Bereich eines MOS-Schalttransistors, geätzt und mit einem leitfähigen Material gefüllt wird, und die untere Elektrode des Speicherkondensators anschließend mindestens teilweise auf dem Kontaktloch aufgebracht wird. Dabei kann zusätzlich vorgesehen sein, daß vor dem Befüllen des Kontaktlochs dieses an seinen Innenwänden mit einer dritten Barriereschicht, insbesondere gegen das Eindringen von Wasserstoff, ausgekleidet wird. Dadurch kann zusätzlich verhindert werden, daß der Wasserstoff in das mit dem leitfähigen Material gefüllte Kontaktloch ("plug") eindiffundiert und durch das leitfähige Material des Kontaktlochs und die untere Elektrode in die metalloxidhaltige Schicht eindringt. Somit ist der hergestellte Speicherkondensator vollständig von Barriereschichten eingekapselt.

Wahlweise kann in dem Verfahrensschritt d) die erste Isolationsschicht bis zu der Tiefe der ersten Barriereschicht entfernt werden, wobei gegebenenfalls die erste Barriereschicht als Ätzstoppschicht verwendet werden kann. Alternativ dazu kann auch im Verfahrensschritt d) die erste Isolationsschicht bis in eine Tiefe unterhalb der ersten Barriereschicht entfernt werden.

Die erste Barriereschicht wird vorzugsweise aus Si3N4 hergestellt, wobei eine chemische Gasphasenabscheidung bei niedrigem Druck (LPCVD) besonders gute Ergebnisse liefert. Als Material der ersten Barriereschicht kann auch ZrO₂ bzw. SiO₂/ZrO₂, gewählt werden. Auch die an sich im Stand der Technik bekannten Materialien Al₂O₃, TiO₂, Ta₂O₅ können als Material für die erste Barriereschicht eingesetzt werden.

Für die dritte Barriereschicht, mit der die Innenwände des in die erste Isolationsschicht geätzten Kontaktlochs ausgekleidet werden, können prinzipiell dieselben Materialien wie für die erste Barriereschicht verwendet werden. Wird als Material für die dritte Barriereschicht Si₃N₄ gewählt, so erfolgt auch hier die Abscheidung vorzugsweise durch LPCVD.

Die auf dem Speicherkondensator abgeschiedene zweite Barriereschicht kann aus einer SiO_{X}-SiON-Si₃N₄-Schichtkombination aufgebaut sein, wobei zuerst vorzugsweise mit CVD (chemical vapour deposition) eine SiOₓ-Schicht aufgewachsen wird, anschließend ebenfalls vorzugsweise mit CVD eine SiON-Schicht abgeschieden wird und schließlich vorzugsweise mit LPCVD eine Si₃N₄-Schicht aufgebracht wird. Um dabei das ferroelektrische oder paraelektrische Material des Dielektrikums vor den relativ großen Mengen an Wasserstoff zu schützen, die bei der LPCVD-Abscheidung der Si₃N₄-Schicht auftreten, kann zusätzlich unterhalb der Schichtkombination oder zwischen einzelnen Schichten der Schichtkombination eine oxidische oder nitridische Barriereschicht (X-Schicht) abgeschieden werden. Der Schichtaufbau der Schichtkombination ist also beispielsweise X-SiO₂-SiON-Si₃N₄ oder SiO₂-X-SiON-Si₃N₄. Als Material für die X-Schicht kann beispielsweise Ta₂O₅, Bi₂O₃, TiO₂, Al₂O₃, Nb₂O₅, MgO, V₂O₅, CeO₂, Y₂O₃, ZrO₂, BN, AlN sowie alle Selten-Erd-Oxide verwendet werden. Um des weiteren eine Schädigung des Ferro- oder Paraelektrikums als Folge der CVD-Abscheidung der Siliziumoxidschicht auszuheilen, wird zudem bevorzugterweise ein Temperschritt nach der SiO_{X}-Abscheidung vorgenommen.

Im folgenden werden Ausführungsbeispiele der Erfindung anhand der Zeichnungen näher erläutert. In den Zeichnungen sind jeweils Querschnittsansichten durch Halbleiterbauelemente in unterschiedlichen Stadien des erfindungsgemäßen Verfahrens dargestellt. Im einzelnen zeigen:
- Fig. 1: ein erfindungsgemäß hergestelltes Halbleiterbauelement nach Durchführung des Verfahrensschritts c);
- Fig. 2a: ein erfindungsgemäß hergestelltes Halbleiterbauelement nach Durchführung des Verfahrensschritts d) (erste Ausführungsart);
- Fig. 2b: ein erfindungsgemäß hergestelltes Halbleiterbauelement nach Durchführung des Verfahrensschritts d) (zweite Ausführungsart);
- Fig. 3: ein erfindungsgemäß hergestelltes Halbleiterbauelement nach Durchführung des Verfahrensschritts e) (erste Ausführungsart).

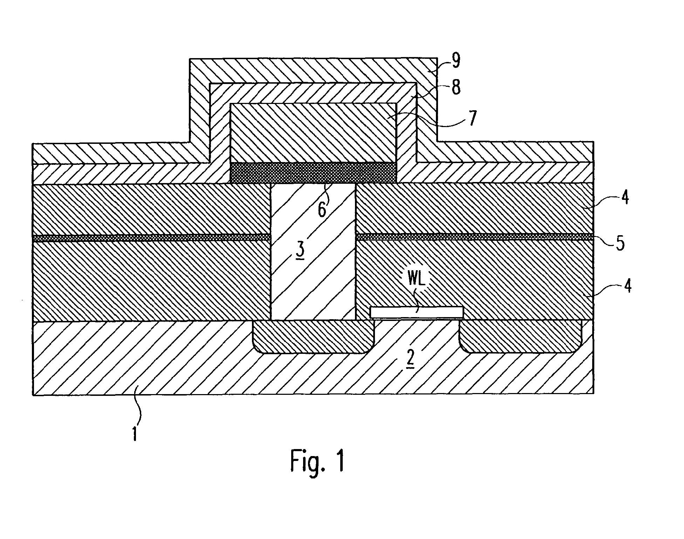

Gemäß dem in Fig. 1 dargestellten Ausführungsbeispiel wird zunächst auf einem Halbleitersubstrat 1 (beispielsweise aus Silizium) ein MOS-Schalttransistor 2 dadurch hergestellt, indem durch Dotierung ein Drain-Gebiet und ein Source-Gebiet gebildet werden, zwischen denen ein Kanal besteht, der durch ein über dem Kanal angeordnetes Gate in seiner Leitfähigkeit gesteuert werden kann. Das Gate kann durch eine Wortleitung WL des Speicherbauelements gebildet oder mit dieser verbunden sein. Das Source-Gebiet ist mit einer Bit-Leitung BL des Speicherbauelements verbunden. Der MOS-Schalttransistor 2 wird anschließend mit einer planarisierenden Isolationsschicht 4, üblicherweise aus einem Oxid, wie SiO₂ (TEOS), oder BPSG (Borphosphor-Silikatglas) bedeckt.

Erfindungsgemäß wird in die Isolationsschicht 4 eine erste Barriereschicht 5 eingebettet. Es wird also zunächst eine erste Teilschicht der Isolationsschicht 4 aufgebracht, dann auf diese erste Teilschicht die Barriereschicht 5 abgeschieden und schließlich auf die Barriereschicht 5 eine zweite Teilschicht der Isolationsschicht 4 aufgebracht. Für die Barriereschicht 5 wird ein Material gewählt, das gegenüber Wasserstoff möglichst undurchdringlich ist. Sehr gut geeignet hierfür ist Siliziumnitrid, insbesondere Si₃N₄, welches in besonders guter Qualität und Porenfreiheit durch chemische Gasphasenabscheidung bei niedrigem Druck (LPCVD) abgeschieden werden kann. Es kann jedoch auch eine andere Nitridschicht oder eine andere als H₂-Barriere fungierende Schicht verwendet werden.

Anschließend wird in den durch die Isolationsschicht 4 und die Barriereschicht 5 gebildeten Schichtaufbau ein Kontaktloch 3 oberhalb des Drain-Gebiets des MOS-Schalttransistors 2 vertikal geätzt und mit einem leitfähigen Material, wie dotiertem, polykristallinem Silizium, aufgefüllt. Auf das gefüllte Kontaktloch 3 wird anschließend eine Oxidationsbarriere 6 aufgebracht.

Anschließend wird auf der Isolationsschicht 4 ein Speicherkondensator geformt, indem zuerst eine untere Elektrode 7 aus Platin oder einem anderen Platinmetall oder einem leitenden Oxid davon über dem Kontaktloch 3 aufgebracht und wie dargestellt mesaförmig strukturiert wird. Die untere Elektrode 7 ist somit mit dem Drain-Gebiet des MOS-Schalttransistors 2 über das mit dem leitfähigen polykristallinen Silizium gefüllte Kontaktloch 3 elektrisch verbunden. Auf die untere Elektrode 7 wird dann eine dielektrische Schicht 8 eines ferroelektrischen oder paraelektrischen Materials abgeschieden, die das Kondensatordielektrikum bildet. Diese Schicht 8 bedeckt die strukturierte untere Elektrode 7 vollständig nach allen Seiten und erstreckt sich in lateraler Richtung stufenförmig über die untere Elektrode 7 hinaus. Auf die dielektrische Schicht 8 wird eine obere Elektrode 9 aus Platin oder einem anderen Platinmetall oder einem leitenden Oxid davon ebenfalls vollständig nach allen Seiten bedeckend abgeschieden und erstreckt sich somit ebenfalls stufenförmig in lateraler Richtung beidseits der strukturierten unteren Elektrode 7.

Somit ist ein Halbleiterbauelement fertiggestellt, wie es in Fig. 1 dargestellt ist.

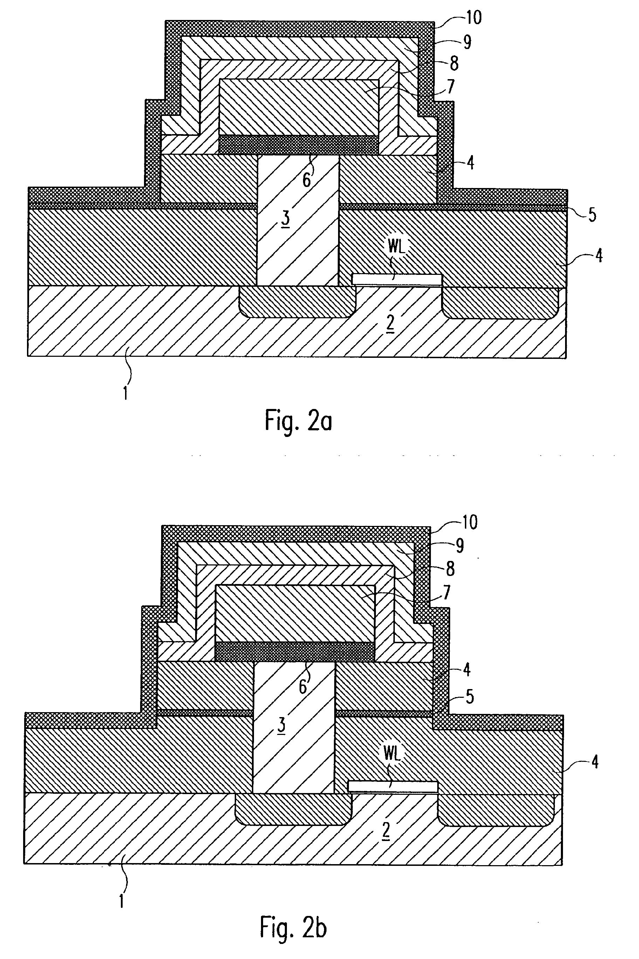

Anschließend wird eine vertikale, mesaförmige Strukturierung des Speicherkondensators durchgeführt. Diese kann nach zwei verschiedenen Ausführungsarten erfolgen, die anhand der Fig. 2a und 2b dargestellt sind.

In einer ersten Ausführungsart (Fig. 2a) wird um den Speicherkondensator eine vertikale Mesastruktur in die Isolationsschicht 4 geätzt, wobei der vertikale Ätzvorgang exakt bis zu der Barriereschicht 5 durchgeführt wird. Gegebenenfalls kann dabei die Barriereschicht 5 gleichzeitig die Funktion einer Ätzstoppschicht übernehmen. Dieser vertikale Ätzschritt hat zum Ergebnis, daß die obere Oberfläche der Barriereschicht 5 außerhalb der geätzten Mesastruktur nach außen freigelegt wird. Auf die erhaltene Struktur wird dann eine zweite Barriereschicht 10 aufgebracht.

Bei der zweiten Ausführungsart (Fig. 2b) wird ebenfalls eine mesaförmige Struktur durch einen vertikalen Ätzschritt um den Speicherkondensator herum erzeugt. In diesem Fall wird jedoch der vertikale Ätzvorgang in die Isolationsschicht 4 über die Barriereschicht 5 hinaus durchgeführt, so daß die Barriereschicht 5 außerhalb der Mesastruktur gänzlich entfernt wird. Der Ätzvorgang erfolgt bis zu einer bestimmten Tiefe unterhalb der Barriereschicht 5 und wird dann gestoppt. Auf die erhaltene Struktur wird dann die zweite Barriereschicht 10 aufgebracht. Bei der zweiten Ausführungsart ist somit kein Ätzstopp auf der Barriereschicht 5 notwendig. Dies wird jedoch mit einer Zunahme der Höhe der Topologie, d.h. der geätzten Mesastruktur erkauft.

Bei beiden Ausführungsarten bewirkt das Aufbringen der zweiten Barriereschicht 10, daß diese an einem bestimmten Abschnitt mit der ersten Barriereschicht 5 verbunden wird. Dieser Abschitt verläuft auf einer geschlossenen Bahn um die Mesastruktur und bildet gewissermaßen die Außenkontur im unteren Bereich der geätzten Mesastruktur. Bei der ersten Ausführungsart wird die zweite Barriereschicht 10 vollständig auf die in dem Bereich außerhalb der Mesastruktur noch vollständig erhaltene erste Barriereschicht 5 aufgebracht. Bei der zweiten Ausführungsart erfolgt die Kontaktierung dagegen an dem schmalen Abschnitt, an dem die erste Barriereschicht 5 an der vertikal geätzten Flanke nach außen frei liegt.

Die zweite Barriereschicht 10 wird aus einer Schichtkombination gebildet, bei der zunächst eine erste Schicht aus SiOₓ, dann eine zweite Schicht bestehend aus SiON und schließlich eine dritte Schicht aus Si₃N₄ aufgebracht wird. Die ersten beiden Schichten können durch CVD (chemical vapour deposition) gebildet werden, während die Si3N4-Schicht durch LPCVD (low pressure chemical vapour deposition, chemische Gasphasenabscheidung bei niedrigem Druck) gebildet werden kann. Um das Dielektrikum des Speicherkondensators vor den relativ großen Mengen an Wasserstoff (H₂) zu schützen, die bei der LPCVD-Abscheidung der Si₃N₄-Schicht auftreten, kann eine zusätzliche oxidische oder nitridische Barriereschicht (X-Schicht) abgeschieden werden. Diese X-Schicht kann entweder als erste Schicht, also noch vor Abscheidung der SiO₂-Schicht, oder innerhalb der Schichtkombination aufgebracht werden. Als Schichtkombination kann somit beispielsweise ein Schichtaufbau gemäß X-SiO₂-SiON-SiN oder SiO₂-X-SiON-SiN gewählt werden. Die X-Schicht kann auch nach Bildung der SiON-Schicht aufgebracht werden. Als Material der oxidischen oder nitridischen X-Barriereschicht kann jedes thermisch stabile, nicht-leitende Oxid oder Nitrid, wie z.B. Ta₂O₅, Bi₂O₃, TiO₂, Al₂O₃, Nb₂O₅, MgO, V₂O₅, CeO₂, Y₂O₃, ZrO₂, BN, AlN sowie alle Selten-Erd-Oxide verwendet werden. Nach der CVD-Abscheidung der Siliziumoxidschicht kann ein Temperschritt durchgeführt werden, um eventuelle Schädigungen des Kondensatordielektrikums als Folge dieser Abscheidung auszuheilen.

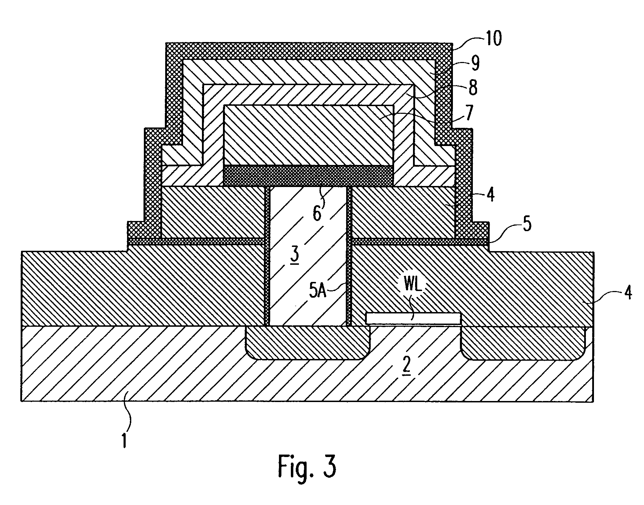

In Fig. 3 ist schließlich noch ein erfindungsgemäß fertigprozessiertes Halbleiterbauelement dargestellt. Wie man sieht, ist dieses aus einem erfindungsgemäßen Verfahren gemäß der ersten Ausführungsart (Fig. 2a) hervorgegangen, wobei in einem weiteren Ätzschritt die außerhalb der Mesastruktur befindlichen Barriereschichten 5 und 10 entfernt wurden.

Das in Fig. 3 dargestellte Halbleiterbauelement unterscheidet sich jedoch noch in einem weiteren Merkmal von den bisher dargestellten Ausführungsarten. Bei diesen ist nämlich das Kontaktloch 3 mit einer dritten Barriereschicht 5A versehen, durch die verhindert wird, daß der Wasserstoff durch die Isolationsschicht 4 in das leitfähige Material des Kontaktlochs 3 eindringen und von dort nach oben in den Speicherkondensator eindiffundieren kann. Die dritte Barriereschicht 5A wird unmittelbar nach der Kontaktlochätzung durchgeführt. Vorzugsweise besteht die dritte Barriereschicht 5A wie auch die erste Barriereschicht 5 aus Si₃N₄ und wird weiterhin vorzugsweise ebenfalls durch das LPCVD-Verfahren hergestellt. Die dritte Barriereschicht 5A bedeckt vollständig die Innenwände des Kontaktlochs 3. Nachdem das Kontaktloch 3 solchermaßen durch die dritte Barriereschicht 5A ausgekleidet wurde, wird das Kontaktloch 3 mit dem leitfähigen Material, wie dotiertem, polykristallinem Silizium, befüllt.

Mit dem erfindungsgemäßen Verfahren gelingt es somit, den Speicherkondensator mit den Barriereschichten 5, 5A und 10 vollständig einzukapseln und somit zu verhindern, daß der in den Prozeßschritten nach Bildung des Speicherkondensators stets vorhandene Wasserstoff in das Bauelement eindringt und Schädigungen an dem ferroelektrischen oder paraelektrischen Material des Kondensatordielektrikums hervorrufen kann. In vielen Fällen wird es ausreichend sein, die Barriereschichten 5 und 10 auszubilden, da das Kontaktloch 3 selbst nur einen sehr engen Diffusionspfad für den Wasserstoff bildet. Um eine vollständige Einkapselung zu erreichen, kann jedoch wie dargestellt auch noch die dritte Barriereschicht 5A an den Innenwänden des Kontaktlochs 3 angebracht und somit die Einkapselung des Speicherkondensators vervollständigt werden.

## Patentansprüche

1. Verfahren zur Herstellung eines Halbleiterbauelements, bei welchem
a) auf einem Halbleitersubstrat (1) ein Schalttransistor (2) geformt wird,
b) auf dem Schalttransistor (2) eine Isolationsschicht (4) aufgebracht wird, in die eine erste Barriereschicht (5), insbesondere gegen das Eindringen von Wasserstoff, eingebettet wird,
c) auf die Isolationsschicht (4) ein mit dem Schalttransistor (2) gekoppelter Speicherkondensator enthaltend eine untere (7) und eine obere Elektrode (9) und eine dazwischen abgeschiedene metalloxidhaltige Schicht (8) aufgebracht wird,
d) in einem vertikalen Ätzschritt die Isolationsschicht (4) außerhalb des Speicherkondensators bis zu einer bestimmten Tiefe entfernt wird, wobei die erste Barriereschicht nach außen freigelegt wird,
e) auf den Speicherkondensator und auf die Isolationsschicht (4) und auf die erste Barriereschicht (5) eine zweite Barriereschicht (10), insbesondere gegen das Eindringen von Wasserstoff, aufgebracht wird.

2. Verfahren nach Anspruch 1,
**dadurch gekennzeichnet,** daß
- der Schalttransistor (2) dadurch mit dem Speicherkondensator verbunden wird, daß nach dem Aufbringen der Isolationsschicht (4) in diese ein Kontaktloch (3) bis zu einem Source- oder Drain-Bereich des Schalttransistors (2) geätzt und mit einem leitfähigen Material gefüllt wird, und
- die untere Elektrode (7) über dem Kontaktloch (3) aufgebracht wird.

3. Verfahren nach Anspruch 2,
**dadurch gekennzeichnet,** daß
- vor dem Befüllen des Kontaktlochs (3) dieses an seinen Innenwänden mit einer dritten Barriereschicht (5A), insbesondere gegen das Eindringen von Wasserstoff, ausgekleidet wird.

4. Verfahren nach Anspruch 1,
**dadurch gekennzeichnet,** daß
- im Verfahrensschritt d) die Isolationsschicht (4) bis zu der Tiefe der ersten Barriereschicht (5) entfernt wird, wobei gegebenenfalls die erste Barriereschicht (5) als Ätzstoppschicht verwendet wird.

5. Verfahren nach Anspruch 1,
**dadurch gekennzeichnet,** daß
- im Verfahrensschritt d) die Isolationsschicht (4) bis in eine Tiefe unterhalb der ersten Barriereschicht (5) entfernt wird.

6. Verfahren nach einem der vorhergehenden Ansprüche,
**dadurch gekennzeichnet,** daß
- die erste Barriereschicht (5) aus Si₃N₄ besteht, welches gegebenenfalls durch chemische Gasphasenabscheidung bei niedrigem Druck (LPCVD) abgeschieden wird.

7. Verfahren nach einem der Ansprüche 1 bis 5,
**dadurch gekennzeichnet,** daß
- die erste Barriereschicht (5) aus ZrO₂ oder den in dieser Reihenfolge abgeschiedenen Schichtmaterialien SiO₂-ZrO₂ oder aus einem der Materialien Al₂O₃, TiO₂, Ta₂O₅ besteht.

8. Verfahren nach einem der vorhergehenden Ansprüche,
**dadurch gekennzeichnet,** daß
- die zweite Barriereschicht (10) durch eine Schichtkombination der in dieser Reihenfolge abgeschiedenen Schichtmaterialien SiOₓ-SiON-Si₃N₄ gebildet wird.

9. Verfahren nach einem der Ansprüche 1 bis 7,
**dadurch gekennzeichnet,** daß
- die zweite Barriereschicht (10) durch eine Schichtkombination der in dieser Reihenfolge abgeschiedenen Schichtmaterialien SiOₓ-Si₃N₄ gebildet wird.

10. Verfahren nach Anspruch 8,
**dadurch gekennzeichnet,** daß
- vor Abscheidung der Si₃N₄-Schicht eine zusätzliche Barriereschicht aus einem Oxid oder einem Nitrid, insbesondere aus einem der Materialien Ta₂O₅, Bi₂O₃, TiO₂, Al₂O₃, Nb₂O₅, MgO, V₂O₅, CeO₂, Y₂O₃, ZrO₂, BN, AlN sowie einem Selten-Erd-Oxid abgeschieden wird.

11. Verfahren nach Anspruch 8 oder 10,
**dadurch gekennzeichnet,** daß
- die SiO_{X}-Schicht und/oder die SiON-Schicht durch ein CVD-Verfahren gebildet werden.

12. Verfahren nach einem der Ansprüche 8 bis 11,
**dadurch gekennzeichnet,** daß
- die Si₃N₄-Schicht durch ein LPCVD-Verfahren gebildet wird.

13. Verfahren nach Anspruch 3,
**dadurch gekennzeichnet,** daß
- die dritte Barriereschicht (5A) aus Si₃N₄ besteht, welches insbesondere durch ein LPCVD-Verfahren abgeschieden wird.

14. Verfahren nach einem der vorhergehenden Ansprüche,
**dadurch gekennzeichnet,** daß
- im Verfahrensschritt c) die untere und/oder die obere Elektrode aus Platin oder einem anderen Platinmetall oder einem Oxid davon hergestellt werden.
